# EUROPEAN PATENT SPECIFICATION

(11) **EP 3 555 979 B1**
(45) Date of publication and mention of the grant of the patent: **21.07.2021**
(21) Application number: 17826465.1
(22) Date of filing: 15.12.2017
(51) Int. Cl.: H02G 5/00, H05K 1/02, H05K 3/46

(54) **LAMINATED MULTI PHASE BUSBAR AND METHOD OF MANUFACTURING THE SAME**
LAMINIERTE MEHRPHASIGE SAMMELSCHIENE UND VERFAHREN ZUR HERSTELLUNG DAVON
BARRE OMNIBUS MULTIPHASE LAMINÉE ET SON PROCÉDÉ DE FABRICATION

(30) Priority: 19.12.2016 EP 16205020
(43) Date of publication of application: 23.10.2019
(73) Proprietor: ABB Schweiz AG, 5400 Baden (CH)
(72) Inventor: VELTHUIS, Rudi, 79787 Lauchringen (DE); MEIER, Guido, 5303 Würenlingen (CH)
(74) Representative: Kesselhut, Wolf
(86) International application number: PCT/EP2017/083065
(87) International publication number: WO 2018/114691

(56) References cited:
- WO-A1-2016/133861
- WO-A2-2012/135673
- DE-A1-102005 015 945
- US-A- 3 264 403
- US-A- 3 663 866
- US-A1- 2001 025 718
- US-A1- 2008 078 572
- US-B1- 6 329 603

## Description

The invention is related to a laminated multi-phase busbar and a method of manufacturing the same according to the preamble of claims 1 and 6.

Multi-phase busbars are used in switchboards to conduct and distribute alternating electrical current to different electrical devices that are usually installed in switch gear cabinets. In order to provide for the possibility to conduct all three phases or even more phases of an alternating current in a single busbar, multi-phase busbars have been developed which comprise a base layer and a cover layer of electrically insulating material between which two or more layers of conducting sheet metal, in particular copper, are arranged that are electrically insulated from each other by means of insulating intermediate layers.

The afore-described laminated busbars are described in DE 10 2005 015 945 B4 of the applicant and have the advantage that they are compact and do not tend to delaminate due to forces generated by eddy currents which are induced by the alternating electric currents that are conducted in the different conducting layers for each phase. A further advantage can be seen in that electrical losses in the busbar system as well as the forces generated by eddy currents are reduced or even locally cancelled due to the phase shifts of the electrical current flow in each of the conducting layers.

One problem of the busbars as described in DE 10 2005 015 945 B4 are the costs involved in the lamination process itself, in which the different layers are bond to each other by means of liquid resin, e.g. epoxy resin. As the resins used for the laminating process usually require specific safety precautions for the staff involved in the production process, the production costs are high. Documents US 3 264 403 A, US 2001/025718 A1, US 2008/078572 A1, WO 2012/135673 A2, US 6 329 603 B1, WO 2016/133861 A1 and US 3 663 866 A disclose further busbar assemblies.

Accordingly, it is a problem of the present invention to provide for a multi-phase busbar which can be produced at reduced costs, has a reduced size, and can be easily assembled in a switchboard cabinet.

This problem is solved by a laminated multi-phase busbar as claimed in claim 1 and a method of manufacturing the same as claimed in claim 6.

Further objects of the present invention are included in the dependent claims.

The invention provides for the advantage that by using SMC material, which has been on the market for nearly 50 years by now, the production costs of the laminated busbar can be significantly reduced.

As the applicant of the present invention has found, the bonding of the SMC material to the metal/copper layers is sufficient to take up the strong magnetic forces which are generated by the electric currents flowing through the conducting layers of the busbar without delaminating the layers. These currents may in case of an electrical short circuit easily reach a magnitude of several thousand Amperes.

The invention is hereinafter described with reference to the accompanying drawings. In the drawings
- Fig. 1: shows a schematic top view of the multi-phase busbar according to the present invention after positioning the stack of uncured layers in a cavity of a schematically indicated mold of a heat molding press,
- Fig. 2: is a schematic side view of the busbar according to the present invention during the production process right after placing the stack of layers in a heated mold and applying pressure to the stack, and
- Fig. 3: is a schematic cross-sectional view of the busbar of Fig. 2 after curing of the sheet molding compound.

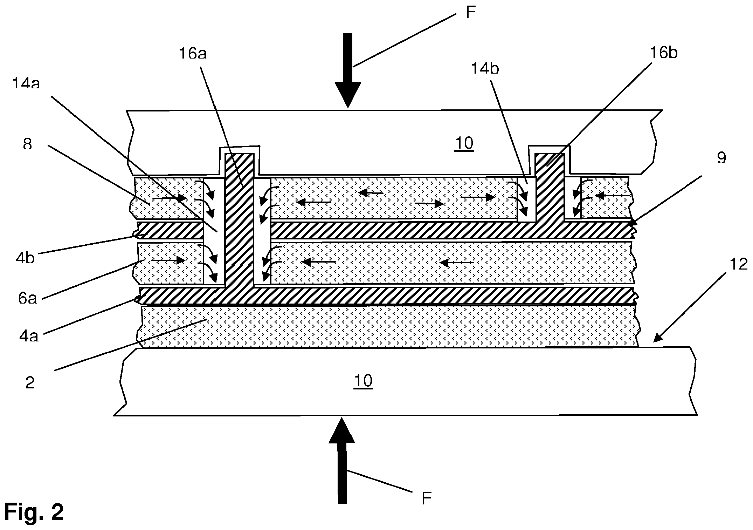

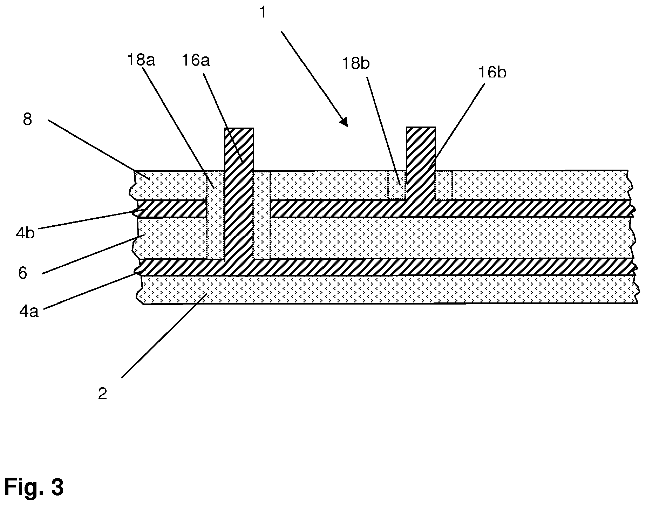

As can be seen best from Figs. 2 and 3, a laminated multi-phase busbar 1 for conducting electric energy comprises a base layer 2 of an electrically insulating material, a first conducting layer 4a of an electrically conducting material which is arranged on said base layer 2. The busbar 1 further comprises a first intermediate insulating layer 6 of an electrically insulating material which is arranged on the first conducting layer 4a, a second conducting layer 4b which is arranged on said first intermediate layer 6 and a cover layer 8. The busbar 1 shown in Figs. 2 and 3 represents a basic configuration of a busbar which is designed to conduct e.g. only one electrical phase and neutral or two electrical phases. For conducting two or even more electrical phases of an electric alternating current, there may be arranged one or more further conducting layers 4 and intermediate layers 6 in between the cover layer 8 and the second conducting layer 4b, which are not shown for reasons of simplification, so that a busbar 1 for conducting three phases and zero may comprise four conducting layers 4 and four intermediate layers 6 in total.

According to the invention, the electrically insulating material of the base layer 2, the cover layer 8 and the intermediate layers 6 is a sheet molding compound which includes a thermosetting resin and reinforcing fibers, e.g. cut glass fibers, having a length of 0, 5 mm to 5 mm. The resin used for such known SMC-material may be a polyester resin or epoxy resin which is partially cured and which includes a curing agent that can be activated by the application of heat. Such SMC-material is a known construction material for housing and casings and the like which is commonly available on the market.

As it can further be seen from Fig. 2 and 3, a first conducting pin 16a for electrically connecting the first conducting layer 4a to an electric energy source (not shown) is mechanically attached or glued to or alternatively integrally formed with the first conducting layer 4a. In the same way, a second conducting pin 16b is mechanically connected to or integrally formed with the second conducting layer 4b. The first conducting pin 16a and second conducting pin 16b extend parallel to each other in a direction which is preferably perpendicular to the different layers 2, 4a, 6, 4b and 8 which are arranged in a stack 9.

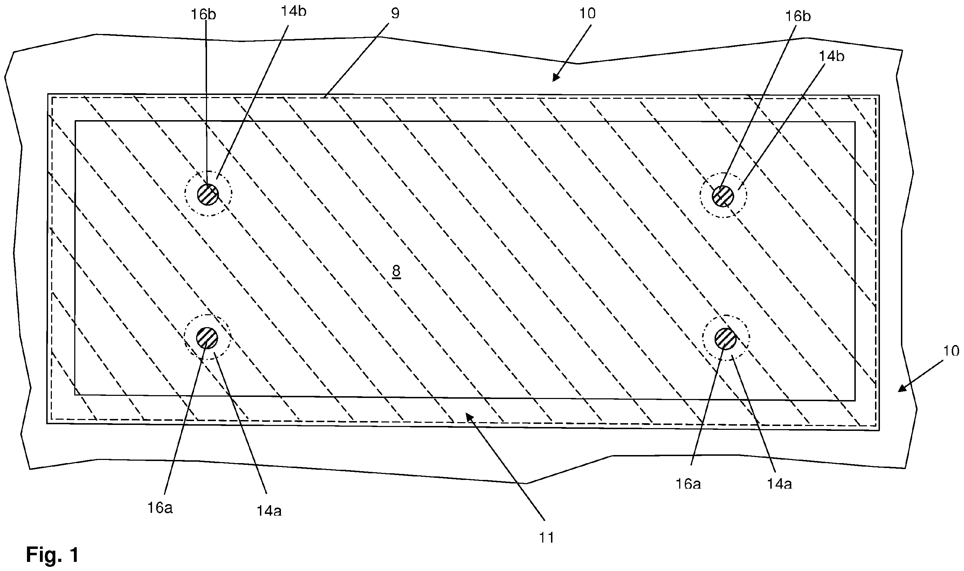

As can be seen in Fig. 1 and in more detail in Fig. 2, the cover layer 8, the second conducting layer 4b and the intermediate layer 6 comprise openings which in the stack 9 form a first pin hole 14a around the first conducting pin 16a. In the same way, the cover layer 8 comprises a further opening which is positioned around the second conducting pin 16b when placing the stack 9 of layers in a cavity 12 of a heated mold 10 of a sheet molding press, as it is schematically indicated in Fig. 1.

In the stack 9 of layers, the first pin holes 14a in the intermediate layer 6, the second conducting layer 4b and the cover layer 8 have a larger diameter than the diameter of the first conducting pin 16a and are aligned along the central longitudinal axis of the conducting pin 16a, in order to form a recess into which the liquefied thermosetting resin of the insulating layer 6 and cover layer 8 can flow when applying a force F to the stack 9 after positioning it in the heated mold 10 (Fig. 2). In the same way, the second pin hole 14b comprises a larger diameter than the second conducting pin 16b, in order to allow the liquefied thermosetting resin and the fibers included therein to flow into the second pin hole 14b during the compression molding process.

The method of manufacturing an afore-described busbar with 2 conducting layers 4a and 4b according to a further aspect of the present invention will now be described with reference to Fig. 1 to 3.

Firstly, the copper/sheet metal of the conducting layers 4a, 4b is preferably pretreated, in particular etched with a known acid or sand blasted, in order to enable a good bonding with the resin. Then the different layers which have preferably been cut to the desired shape and size before, are arranged above each other in a stack 9 and the entire stack 9 of materials is placed in the cavity 12 of a heated mold 10 of a compression molding press and the mold 10 is closed as indicated by the dashed lines in Fig. 1.

The heat of the mold 10 in combination with the pressure, which may be in the range of several thousand MPa, reduces the viscosity of the initially semi-rigid resin and causes the resin and the fibers included therein to flow into the pin holes 14a and 14b and other openings and recesses (not shown) which may be formed in the conducting layers and insulating layers. Moreover, the liquefied resin and fibers also flow into the space 11 which is arranged around the outer edges of the layers/stack 9 and the inner wall of the mold 10 which define the cavity 12, thereby forming a layer of insulating material on the outside of the stack 9 which advantageously electrically insulates the outer edges of the conducting layers 4a, 4b without employing additional steps. In other words, the copper layers 4a, 4b are now completely encapsulated by the resin of the SMC material, whereby the high
pressure not only presses the material into any openings and cavities in the conducting material, but also reduces the size of any voids which may be initially included in the original SMC-layers.

The distance between the copper layers 4a, 4b is provided by the fact that the SMC-layers 2, 6 and 8 are preferably cut in such a way that little material flow can take place. Before the compression molding is started, preferably 90 % of the mold 10 is covered with SMC, the remaining 10 % is filled after the compression.

To do so, the mold 10 for receiving the stack of layers 2, 4a, 4b, 6, 8 preferably comprises a cubical cavity 12 which has a first cross section when viewed in the direction of the conducting pins 16a, 16b (Fig. 1). The layers 2, 4a, 4b, 6, 8 included in the stack 9 comprise a second cross section which has a surface area that covers between 80% and 95%, preferably 90% of the area of the first cross section. By lowering the dye of the sheet molding press (which is indicated in Fig. 1 in dashed lines) into the mold cavity 12, the viscosity of the partially cured SMC-material of the base layer 2, cover layer 8 and the insulating layer(s) 6 is reduced and the resin and fibers flow into the space 11 until it is entirely filled up with resin.

After a predetermined period of time, e.g. 8 to 10 min, the mold is opened and the hot cured stack 9 of layers is removed from the press cavity 12, in order to allow the stack 9 to cool down. After the stack 9 has cooled down to room temperature and the resin has cured completely, the conducting pins 16a, 16b may be cleaned, and the terminals or shipping splits may be deflashed if necessary. As can be seen from Fig. 3, the conducting pins 16a, 16b are mechanically bonded to the insulating layers 6 and to the cover layer 8 by material bridges 18a, 18b of cured resin and fibers which also contribute to hold the stack 9 together in case of the occurrence of delaminating forces which act upon the conducting layers 4a, 4b when short circuiting the conducting layers 4a, 4b .

In order to ease the removal of the hot stack 9 from the mold 10, the base layer 2 and/or the cover layer 8 may include an internal release agent which prevents the base layer 2 and/or the cover layer 8 from adhering to heated parts of the mold 10.

### Listing of reference signs

- 1: busbar
- 2: base layer
- 4a: first conducting layer
- 4b: second conducting layer
- 6: first intermediate layer
- 8: cover layer
- 9: stack/sandwich of layers
- 10: heated mold of sheet molding press
- 11: space between inner wall of cavity and stack
- 12: cavity of mold
- 14a: first pin hole
- 14b: second pin hole
- 16a: first conducting pin
- 16b: second conducting pin
- 18a: material bridge around first conducting pins
- 18b: material bridge around second conducting pins
- F: compressive force

## Claims

1. Laminated multi-phase busbar (1) for conducting electric energy, comprising a base layer (2) of an electrically insulating material,
a first conducting pin (16a),
a first conducting layer (4a) of an electrically conducting material which is arranged on and mechanically connected to said base layer (2),
a first intermediate insulating layer (6) of an electrically insulating material which is arranged on and mechanically connected to said first conducting layer (4a),
a second conducting layer (4b) of an electrically conducting material which is arranged on and mechanically connected to said first intermediate layer (6) and
a cover layer (8) of an electrically insulating material which is arranged on and mechanically connected to said second conducting layer (4b),
wherein the electrically insulating material of said base layer (2), said first intermediate layer (6) and said cover layer (8) is a sheet molding compound including a thermosetting resin and reinforcing fibers, and the material of said first conducting layer (4a) and said second conducting layer (4b) is a sheet metal which is mechanically connected to the intermediate insulating layer by a thermally cured thermosetting resin, wherein at least one first pin hole (14a) is formed in said first intermediate insulating layer (6), said second conducting layer (4b) and said cover layer (8), and said first conducting pin (16a) for conducting electric energy to said first conducting layer (4a) is arranged inside said first pin hole (14a), said first conducting pin (16a) being electrically connected to said first conducting layer (4a) and having a smaller diameter than said first pin hole (14a) in said second conducting layer (4b), wherein said first conducting pin (16a) is mechanically bonded to the intermediate insulating layer (6) and to the cover layer (8) by a material bridge (18a) made of said thermosetting resin and reinforcing fibers from said first intermediate insulating layer (6) and from said cover layer (8).

2. Laminated multi-phase busbar according to claim 1,
**characterized in that** the sheet molding compound includes a thermally curable polyester or epoxy resin and/or chopped glass fibers.

3. Laminated multi-phase busbar according to any of the previous claims, **characterized in that** the base layer (2) comprises a release agent which reduces the bonding forces between the thermally cured thermosetting resin of said base layer (2) and said sheet metal of said first electrically conducting layer (4a), and/or that the cover layer comprises a release agent which reduces the bonding forces between the thermally cured thermosetting resin of said cover layer (8) and said sheet metal of said second electrically conducting layer (4b), and that said intermediate insulating layer (6) includes no internal release agent.

4. Laminated multi-phase busbar according to any of the previous claims, **characterized in that** at least one second pin hole (14b) is formed in said cover layer (8), and that a second conducting pin (16b) for conducting electric energy to said second conducting layer (4b) is arranged inside said second pin hole (14b), said second conducting pin (16b) being electrically connected to said second conducting layer (4b) and having a smaller diameter than said second pin hole (14b).

5. Laminated multi-phase busbar according to any of the previous claims, **characterized in that** at least one further electrically conducting layer (4) and a further intermediate insulating layer (6) of a sheet molding compound are arranged in between said cover layer (8) and said second conducting layer (4b) for conducting a further electrical phase of said electric energy.

6. Method of manufacturing a multi-phase busbar according to any of the preceding claims comprising the following method steps:
- forming a stack including at least
**a)** a base layer (2) of an uncured sheet molding compound,
**b)** a first conducting layer (4a) of a sheet metal
**c)** an intermediate layer (6) of an uncured sheet molding compound,
**d)** a second conducting layer (4b) of a sheet metal and
**e)** a cover layer (8) of an uncured sheet molding compound,
wherein said sheet molding compound includes a partially cured thermosetting resin and reinforcing fibers which are movable within said resin, providing a first conducting pin (16a) having a smaller diameter than said first pin hole (14a),
- providing at least one first pin hole (14a) in said stack, said first pin hole extending from said cover layer to said first conducting layer and arranging a first conducting pin (16a) contacting said first conducting layer (4a) inside said first pin hole (14a),
- providing at least one second pin hole (14b) in said stack, said second pin hole (14b) extending from said cover layer (4a) to said second conducting layer (4b) and arranging a second conducting pin (16b) contacting said second conducting layer (4b) inside said second pin hole (14b), said second pin hole comprising a larger diameter than said second conducting pin (16b),
- placing said stack inside a heated mold (10) of a press, closing said mold (10) and applying pressure to said press for a predetermined period of time, said pressure having a level which enables the resin and the fibers of said sheet molding component to flow into said first and second pin holes (14a, 14b), and
- opening said mold (10) and removing said cured stack from said mold (10).

7. Method of claim 6,
**characterized in that** the mold (10) for receiving the stack of layers (2, 4a, 4b, 6, 8) comprises a cubical cavity having a first cross section when viewed in the direction of the conducting pins (16a, 16b), and that the layers included in the stack (2, 4a, 4b, 6, 8) comprise a second cross
section having a surface area which covers between 80% and 95%, preferably 90% of the area of the first cross section.

8. Method of claim 6 or 7,
**characterized in that** said first and the second conducting layers (4a, 4b) are formed of copper, and that said copper is pretreated, in particular etched and/or sand blasted, before arranging said sheet metal between said layers (2, 6 and 8) of uncured sheet molding compound.

9. Method according to claim 7 or 8,
**characterized in that** the base layer (2) and/or the cover layer (8) include an internal release agent which prevents the base layer (2) and/or the cover layer (8) from adhering to heated parts of the mold (10).

## Patentansprüche

1. Laminierte mehrphasige Sammelschiene (1) zum Leiten von elektrischer Energie, umfassend eine Basisschicht (2) aus einem elektrisch isolierenden Material,
einen ersten leitenden Stift (16a),
eine erste leitende Schicht (4a) aus einem elektrisch leitenden Material, die auf der Basisschicht (2) angeordnet und mechanisch damit verbunden ist,
eine erste isolierende Zwischenschicht (6) aus einem elektrisch isolierenden Material, die auf der ersten leitenden Schicht (4a) angeordnet und mechanisch damit verbunden ist,
eine zweite leitende Schicht (4b) aus einem elektrisch leitenden Material, die auf der ersten Zwischenschicht (6) angeordnet und mechanisch damit verbunden ist, und eine Deckschicht (8) aus einem elektrisch isolierenden Material, die auf der zweiten leitenden Schicht (4b) angeordnet und mechanisch damit verbunden ist,
wobei das elektrisch isolierende Material der Basisschicht (2), der ersten Zwischenschicht (6) und der Deckschicht (8) eine Harzmatte ist, die ein duroplastisches Harz und Verstärkungsfasern umfasst, und das Material der ersten leitenden Schicht (4a) und der zweiten leitenden Schicht (4b) ein Metallblech ist, das mit der isolierenden Zwischenschicht durch ein wärmegehärtetes duroplastisches Harz mechanisch verbunden ist,
wobei mindestens ein erstes Stiftloch (14a) in der ersten isolierenden Zwischenschicht (6), der zweiten leitenden Schicht (4b) und der Deckschicht (8) ausgebildet ist, und der erste leitende Stift (16a) zum Leiten von elektrischer Energie zur ersten leitenden Schicht (4a) innerhalb des ersten Stiftlochs (14a) angeordnet ist, der erste leitende Stift (16a) mit der ersten leitenden Schicht (4a) elektrisch verbunden ist und einen kleineren Durchmesser als das erste Stiftloch (14a) in der zweiten leitenden Schicht (4b) aufweist, wobei der erste leitende Stift (16a) durch eine Materialbrücke (18a), die aus dem duroplastischen Harz und den Verstärkungsfasern von der ersten isolierenden Zwischenschicht (6) und von der Deckschicht (8) hergestellt ist, mechanisch an die isolierende Zwischenschicht (6) und an die Deckschicht (8) gebunden ist.

2. Laminierte mehrphasige Sammelschiene nach Anspruch 1,
**dadurch gekennzeichnet, dass** die Harzmatte ein wärmehärtbares Polyester oder Epoxidharz und/oder zerhackte Glasfasern umfasst.

3. Laminierte mehrphasige Sammelschiene nach einem der vorhergehenden Ansprüche, **dadurch gekennzeichnet, dass** die Basisschicht (2) ein Trennmittel umfasst, das die Haftkräfte zwischen dem wärmegehärteten duroplastischen Harz der Basisschicht (2) und dem Metallblech der ersten elektrisch leitenden Schicht (4a) verringert, und/oder dass die Deckschicht ein Trennmittel umfasst, das die Haftkräfte zwischen dem wärmegehärteten duroplastischen Harz der Deckschicht (8) und dem Blechmetall der zweiten elektrisch leitenden Schicht (4b) verringert, und dass die isolierende Zwischenschicht (6) kein internes Trennmittel umfasst.

4. Laminierte mehrphasige Sammelschiene nach einem der vorhergehenden Ansprüche, **dadurch gekennzeichnet, dass** mindestens ein zweites Stiftloch (14b) in der Deckschicht (8) ausgebildet ist, und dass ein zweiter leitender Stift (16b) zum Leiten von elektrischer Energie zur zweiten leitenden Schicht (4b) innerhalb des zweiten Stiftlochs (14b) angeordnet ist, wobei der zweite leitende Stift (16b) mit der zweiten leitenden Schicht (4b) elektrisch verbunden ist und einen kleineren Durchmesser als das zweite Stiftloch (14b) aufweist.

5. Laminierte mehrphasige Sammelschiene nach einem der vorhergehenden Ansprüche, **dadurch gekennzeichnet, dass** mindestens eine weitere elektrisch leitende Schicht (4) und eine weitere isolierende Zwischenschicht (6) aus einer Harzmatte zwischen der Deckschicht (8) und der zweiten leitenden Schicht (4b) zum Leiten einer weiteren elektrischen Phase der elektrischen Energie angeordnet sind.

6. Verfahren zur Herstellung einer mehrphasigen Sammelschiene nach einem der vorhergehenden Ansprüche, umfassend die folgenden Verfahrensschritte:
- Bilden eines Stapels mit mindestens
a) einer Basisschicht (2) aus einer ungehärteten Harzmatte,
b) einer ersten leitenden Schicht (4a) aus einem Metallblech,
c) einer Zwischenschicht (6) aus einer ungehärteten Harzmatte,
d) einer zweiten leitenden Schicht (4b) aus einem Metallblech, und
e) einer Deckschicht (8) aus einer ungehärteten Harzmatte,
wobei die Harzmatte ein teilweise gehärtetes duroplastisches Harz und Verstärkungsfasern umfasst, die innerhalb des Harzes beweglich sind,
- Bereitstellen eines ersten leitenden Stifts (16a), der einen kleineren Durchmesser als das erste Stiftloch (14a) aufweist,
- Bereitstellen mindestens eines ersten Stiftlochs (14a) im Stapel, wobei das erste Stiftloch sich von der Deckschicht zur ersten leitenden Schicht erstreckt, und Anordnen eines ersten leitenden Stifts (16a), der mit der ersten leitenden Schicht (4a) in Kontakt tritt, innerhalb des ersten Stiftlochs (14a),
- Bereitstellen mindestens eines zweiten Stiftlochs (14b) im Stapel, wobei das zweite Stiftloch (14b) sich von der Deckschicht (4a) zur zweiten leitenden Schicht (4b) erstreckt, und Anordnen eines zweiten leitenden Stifts (16b), der mit der zweiten leitenden Schicht (4b) in Kontakt tritt, innerhalb des zweiten Stiftlochs (14b), wobei das zweite Stiftloch einen größeren Durchmesser als der zweite leitende Stift (16b) aufweist,
- Anordnen des Stapels innerhalb eines beheizten Formwerkzeugs (10) einer Presse, Schließen des Formwerkzeugs (10) und Anwenden von Druck auf die Presse für eine vorbestimmte Zeitdauer, wobei der Druck eine Größe aufweist, die es ermöglicht, dass das Harz und die Fasern der Harzmattenkomponente in das erste und das zweite Stiftloch (14a, 14b) fließen, und
- Öffnen des Formwerkzeugs (10) und Herausnehmen des gehärteten Stapels aus dem Formwerkzeug (10).

7. Verfahren nach Anspruch 6,
**dadurch gekennzeichnet, dass** das Formwerkzeug (10) zum Aufnehmen des Stapels von Schichten (2, 4a, 4b, 6, 8) eine kubische Kavität mit einem ersten Querschnitt in Richtung der leitenden Stifte (16a, 16b) betrachtet umfasst, und dass die im Stapel umfassten Schichten (2, 4a, 4b, 6, 8) einen zweiten Querschnitt mit einer Oberfläche besitzen, die 80 % bis 95 %, vorzugsweise 90 % der Fläche des ersten Querschnitts bedeckt.

8. Verfahren nach Anspruch 6 oder 7,
**dadurch gekennzeichnet, dass** die erste und die zweite leitende Schicht (4a, 4b) aus Kupfer gebildet sind, und dass das Kupfer vor dem Anordnen des Metallblechs zwischen den Schichten (2, 6 und 8) aus ungehärteten Harzmatten vorbehandelt, insbesondere geätzt und/oder sandgeblasen wird.

9. Verfahren nach Anspruch 7 oder 8,
**dadurch gekennzeichnet, dass** die Basisschicht (2) und/oder die Deckschicht (8) ein internes Trennmittel (2) umfassen, das verhindert, dass die Basisschicht (2) und/oder die Deckschicht (8) an beheizten Teilen des Formwerkzeugs (10) haften bleiben.

## Revendications

1. Barre omnibus multiphase stratifiée (1) pour conduire de l'énergie électrique, comprenant une couche de base (2) d'un matériau électriquement isolant,
une première broche conductrice (16a),
une première couche conductrice (4a) d'un matériau électriquement conducteur qui est agencée sur et mécaniquement connectée à ladite couche de base (2),
une première couche isolante intermédiaire (6) d'un matériau électriquement isolant qui est agencée sur et mécaniquement connectée à ladite première couche conductrice (4a),
une seconde couche conductrice (4b) d'un matériau électriquement conducteur qui est agencée sur et mécaniquement connectée à ladite première couche intermédiaire (6) et une couche de couverture (8) d'un matériau électriquement isolant qui est agencée sur et mécaniquement connectée à ladite seconde couche conductrice (4b),
dans laquelle le matériau électriquement isolant de ladite couche de base (2), de ladite première couche intermédiaire (6) et de ladite couche de couverture (8) est un préimprégné en feuille incluant une résine thermodurcissable et des fibres de renforcement, et le matériau de ladite première couche conductrice (4a) et de ladite seconde couche conductrice (4b) est une tôle qui est mécaniquement connectée à la couche isolante intermédiaire par une résine thermodurcissable thermiquement durcie,
dans laquelle au moins un premier trou d'aiguille (14a) est formé dans ladite première couche isolante intermédiaire (6), ladite seconde couche conductrice (4b) et ladite couche de couverture (8), et ladite première broche conductrice (16a) pour conduire de l'énergie électrique jusqu'à ladite première couche conductrice (4a) est agencée à l'intérieur dudit premier trou d'aiguille (14a), ladite première broche conductrice (16a) étant électriquement connectée à ladite première couche conductrice (4a) et ayant un diamètre plus petit que ledit premier trou d'aiguille (14a) dans ladite seconde couche conductrice (4b), dans laquelle ladite première broche conductrice (16a) est mécaniquement liée à la couche isolante intermédiaire (6) et à la couche de couverture (8) par un pont de matériau (18a) fait de ladite résine thermodurcissable et desdites fibres de renforcement de ladite première couche isolante intermédiaire (6) et de ladite couche de couverture (8).

2. Barre omnibus multiphase stratifiée selon la revendication 1,
**caractérisée en ce que** le préimprégné en feuille inclut un polyester ou une résine époxy thermiquement durcissable et/ou des fibres de verre coupées.

3. Barre omnibus multiphase stratifiée selon l'une quelconque des revendications précédentes, **caractérisée en ce que** la couche de base (2) comprend un agent de démoulage qui réduit les forces de liaison entre la résine thermodurcissable thermiquement durcie de ladite couche de base (2) et ladite tôle de ladite première couche électriquement conductrice (4a), et/ou que la couche de couverture comprend un agent de démoulage qui réduit les forces de liaison entre la résine thermodurcissable thermiquement durcie de ladite couche de couverture (8) et ladite tôle de ladite seconde couche électriquement conductrice (4b), et que ladite couche isolante intermédiaire (6) n'inclut aucun agent de démoulage interne.

4. Barre omnibus multiphase stratifiée selon l'une quelconque des revendications précédentes, **caractérisée en ce qu'**au moins un second trou d'aiguille (14b) est formé dans ladite couche de couverture (8), et qu'une seconde broche conductrice (16b) pour conduire de l'énergie électrique jusqu'à ladite seconde couche conductrice (4b) est agencée à l'intérieur dudit second trou d'aiguille (14b), ladite seconde broche conductrice (16b) étant électriquement connectée à ladite seconde couche conductrice (4b) et ayant un diamètre plus petit que ledit second trou d'aiguille (14b).

5. Barre omnibus multiphase stratifiée selon l'une quelconque des revendications précédentes, **caractérisée en ce qu'**au moins une couche électriquement conductrice supplémentaire (4) et une couche isolante intermédiaire supplémentaire (6) d'un préimprégné en feuille sont agencées dans entre ladite couche de couverture (8) et ladite seconde couche conductrice (4b) pour conduire une phase électrique supplémentaire de ladite énergie électrique.

6. Procédé de fabrication d'une barre omnibus multiphase selon l'une quelconque des revendications précédentes, comprenant les étapes de procédé suivantes :
- la formation d'un empilement incluant au moins
a) une couche de base (2) d'un préimprégné en feuille non durci,
b) une première couche conductrice (4a) d'une tôle,
c) une couche intermédiaire (6) d'un préimprégné en feuille non durci,
d) une seconde couche conductrice (4b) d'une tôle, et
e) une couche de couverture (8) d'un préimprégné en feuille non durci,
dans lequel ledit préimprégné en feuille inclut une résine thermodurcissable partiellement durcie et des fibres de renforcement qui sont mobiles à l'intérieur de ladite résine,
- la fourniture d'une première broche conductrice (16a) ayant un diamètre plus petit que ledit premier trou d'aiguille (14a),
- la fourniture d'au moins un premier trou d'aiguille (14a) dans ledit empilement, ledit premier trou d'aiguille s'étendant depuis ladite couche de couverture jusqu'à ladite première couche conductrice et l'agencement d'une première broche conductrice (16a) entrant en contact avec ladite première couche conductrice (4a) à l'intérieur dudit premier trou d'aiguille (14a),
- la fourniture d'au moins un second trou d'aiguille (14b) dans ledit empilement, ledit second trou d'aiguille (14b) s'étendant depuis ladite couche de couverture (4a) jusqu'à ladite seconde couche conductrice (4b) et l'agencement d'une seconde broche conductrice (16b) entrant en contact avec ladite seconde couche conductrice (4b) à l'intérieur dudit second trou d'aiguille (14b), ledit second trou d'aiguille comprenant un diamètre plus grand que ladite seconde broche conductrice (16b),
- le placement dudit empilement à l'intérieur d'un moule chauffé (10) d'une presse, la fermeture dudit moule (10) et l'application d'une pression sur ladite presse pendant une période prédéterminée, ladite pression ayant un niveau qui permet à la résine et aux fibres dudit préimprégné en feuille de s'écouler dans lesdits premier et second trous d'aiguille (14a, 14b), et
- l'ouverture dudit moule (10) et l'enlèvement dudit empilement durci à partir dudit moule (10).

7. Procédé selon la revendication 6,
**caractérisé en ce que** le moule (10) pour recevoir l'empilement de couches (2, 4a, 4b, 6, 8) comprend une cavité cubique ayant une première section transversale en vue dans la direction des broches conductrices (16a, 16b), et que les couches incluses dans l'empilement (2, 4a, 4b, 6, 8) comprennent une seconde section transversale ayant une superficie qui couvre entre 80 % et 95 %, de préférence 90 % de la superficie de la première section transversale.

8. Procédé selon la revendication 6 ou 7,
**caractérisé en ce que** ladite première et la seconde couches conductrices (4a, 4b) sont formées de cuivre, et que ledit cuivre est prétraité, en particulier gravé et/ou sablé, avant l'agencement de ladite tôle entre lesdites couches (2, 6 et 8) de préimprégné en feuille non durci.

9. Procédé selon la revendication 7 ou 8,
**caractérisé en ce que** la couche de base (2) et/ou la couche de couverture (8) incluent un agent de démoulage interne qui empêche la couche de base (2) et/ou la couche de couverture (8) d'adhérer à des parties chauffées du moule (10).
